(19)

**Europäisches Patentamt**
**European Patent Office**
**Office européen des brevets**

(11) **EP 4 769 201 A1**

(12) **EUROPEAN PATENT APPLICATION**

(43) Date of publication:
**01.07.2026 Bulletin 2026/27**

(21) Application number: **25226604.4**

(22) Date of filing: **22.12.2025**

(51) International Patent Classification (IPC):
***G06F 30/33*** *(2020.01)*

(52) Cooperative Patent Classification (CPC):
**G06F 30/33**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **30.12.2024 US 202419005416**

(71) Applicant: **Microsoft Technology Licensing, LLC Redmond, WA 98052 (US)**

(72) Inventors:
• **CHANDRAN, Ajay Kesava**
  **Redmond, Washington 98052 (US)**
• **HEGDE, Sridhar**
  **Redmond, Washington 98052 (US)**

(74) Representative: **CMS Cameron McKenna Nabarro Olswang LLP**
**Cannon Place**
**78 Cannon Street**
**London EC4N 6AF (GB)**

(54) **ACCELERATED COVERAGE CLOSURE IN HARDWARE DESIGNS USING HIERARCHICAL TEST BENCHES**

(57) Improved hardware design testing techniques qualify a current design by integrating select tests completed on prior design iterations. A product design may be divided into design unit subcomponents, and multiple test benches may individually be configured to test different groups of subcomponents. The test benches may be run on a series of iterations of an evolving product design.

Qualification of a most recent current iteration of the product design can be simplified by incorporating some test results from tests performed on prior iteration checkpoints of the design into the qualification of the current design by first combining test results across time for each test bench, and then combining test results across the set of test benches.

**FIG. 1**
**100**

## Description

### BACKGROUND

Complex computer hardware designs require complex testing. Lengthy test processes can delay the release of a product by days or weeks. Manufacturing large integrated circuit logic devices, such as system-on-a-chip, is generally delayed until testing can provide a high degree of confidence in quality or correctness of the device's design. Modifying a product design after manufacturing has started can incur significant financial costs. Such thorough testing on complex products can take weeks after the product design is completed before "tape-out" or manufacturing is started.

A test process for a complex integrated circuit product will typically be formalized to include a predetermined target test coverage percentage for each of several different test metrics. Many different test metrics can used, such as a code coverage metric measuring lines of code in a hardware description language (HDL) exercised during a test, toggle coverage metric measuring number of gates that change state during a test, state coverage metric measuring a number of possible states used in a finite state machine during a test, etc.

### SUMMARY

Improved hardware design testing techniques qualify a current design by integrating select tests completed on prior design iterations. A product design may be divided into design unit subcomponents, and multiple test benches may individually be configured to test different (possibly overlapping) groups of subcomponents. The test benches may be run on a series of iterations of an evolving product design. Qualification of a most recent current iteration of the product design can be simplified by incorporating select test results from tests performed on prior iteration checkpoints of the design into the qualification of the current design by first combining test results across time for each test bench, and then combining test results across the set of test benches. By selectively reusing test results from prior designs, the time and test resources required to qualify a current design can be reduced.

By dividing a product design into design unit subcomponents early in the design process, perhaps even before the designs for any of the design units have even been started, the test benches can be configured to map to the design unit subcomponents early in the design process. Then, as the designs for some initial design units are started, those initial design units can be qualified by corresponding test bench(es), and test results saved for later combination with future testing on later design iterations.

The product design may evolve with new design units added and/or removed in subsequent iterations of the product design. In an aspect, the product design may be divided into a hierarchy of design unit subcomponents, where a high-level design unit includes other lower-level design units. When combining test results across design iterations, test results from individual benches are combined across time by including only prior results that correspond to design units that exist in the current product design and excluding prior results corresponding to any design units that do not exist in the current design. This may prevent prior test results that do not correspond to a current design from being used to qualify the current design.

Features and technical benefits other than those explicitly described above will be apparent from a reading of the following Detailed Description and a review of the associated drawings. This Summary is provided to introduce a selection of concepts in a simplified form that are further described below in the Detailed Description. This Summary is not intended to identify key or essential features of the claimed subject matter, nor is it intended to be used as an aid in determining the scope of the claimed subject matter. The term "techniques," for instance, may refer to system(s), method(s), computer-readable instructions, module(s), algorithms, hardware logic, and/or operation(s) as permitted by the context described above and throughout the document.

### BRIEF DESCRIPTION OF THE DRAWINGS

The Detailed Description is described with reference to the accompanying figures. In the figures, the left-most digit(s) of a reference number identifies the figure in which the reference number first appears. The same reference numbers in different figures indicate similar or identical items. References made to individual items of a plurality of items can use a reference number with a letter of a sequence of letters to refer to each individual item. Generic references to the items may use the specific reference number without the sequence of letters.

FIG. 1 depicts an example test system for testing a product design.
FIG. 2 depicts an example merging process for example test results.
FIG. 3 depicts an example method for integration of test results.
FIG. 4 depicts a block diagram of a computing-based device that may be included in an example of any of the above systems.

### DETAILED DESCRIPTION

Complex computer hardware designs require complex testing in order to qualify a product design and start manufacturing of the product. Complex testing requires time and can require significant computing resources. Hence, there is need for new testing methodologies that reduce the required time and/or computing resources required to qualify a current version of an evolving product design as being ready to start a phase of manufacturing.

Improved hardware design testing techniques qualify a current design by integrating select tests completed on prior design iterations. A product design may be divided into design unit subcomponents, and multiple test benches may individually be configured to test different (possibly overlapping) groups of subcomponents. The test benches may be run on a series of iterations (or design checkpoint times) of an evolving product design. Qualification of the most recent design iteration can be simplified by incorporating select test results from tests previously performed on prior iterations into the qualification of the most recent design. Integration of test results may include first combining test results across time for individual test benches, and then combining test results across the set of test benches. By selectively reusing test results from prior designs, the time and test resources required to qualify a current design can be reduced.

By dividing product design into design unit subcomponents early in the design process, perhaps before the designs for some or any of the design units have even been started, the test benches can be configured to map to the design unit subcomponents early in the design process. Then, as the designs for some initial design units are completed, those initial design units can be qualified by corresponding test bench(es), and test results saved for later combination with future testing on later design iterations.

The product design may evolve with new design units added and/or removed in subsequent iterations of the product design. In an aspect, the product design may be divided into a hierarchy of design unit subcomponents, where a high-level design unit includes other lower-level design units. When combining test results across design iterations, test results from individual benches are combined across time by including only prior results that correspond to design units that exist in the current product design and excluding prior results corresponding to any design units that do not exist in the current design. This may prevent prior test results that do not correspond to a current design from being used to qualify the current design.

In some embodiments, one or more databases can be used to store test results from the test benches run at different design checkpoint times. A test integration tool may combine the test results from the benches run on various design iterations and the integrated test results may also be stored in a database. In other aspects, the integrated test results may be compared to predetermined release criteria. When the integrated test results for a current design iteration meet the criteria, the current design may be released to start manufacturing according to the current design.

In some embodiments, a list of possible test metrics is determined early in the product design process, and all test benches measure one or more of the metrics from the same list of possible tests. In an aspect, all test benches measure the same metrics from the list for different subsets of design units in the design. In this aspect, a test integration tool may combine the same metrics from the various test results into an integrated test result that also include measurements of the same metrics. In other aspects, different test benches may measure different metrics from the list of possible test metrics, and the test integration tool will combine the different metrics into the integrated test results.

In some embodiments, a sliding time window may be used when combining test results across time. For example, a sliding window of three design checkpoint times may be used to include a current design and the two immediate previous design checkpoint times while excluding test results from design iterations prior to two checkpoint before the current design time. Such a sliding window may help to ensure the freshness of test results included the integrated results for the current design. Such a sliding window may, for example, limit the extent to which design changes that are hidden from the test system are able to affect the qualification of the current design by explicitly ignoring test results from long before the current design checkpoint.

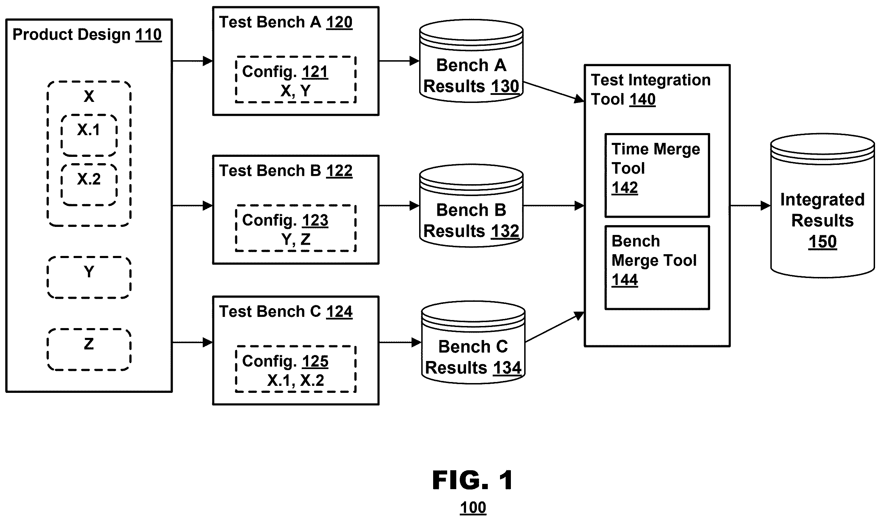

FIG. 1 depicts an example test system 100 for testing a product design 110. Example test system 100 includes a product design 110, test benches A 120, B 122, and C 124, corresponding bench results A 130, B 132, and C 134, a test integration tool 140, and integrated results 150. Product design 110 may evolve over design checkpoint times. Test benches A 120, B 122, and C 124 perform design qualification tests on product design 110 to produce test results that are stored in as corresponding bench results A 130, B 132, and C 134 for each design checkpoint time tested. As depicted in FIG. 1, bench results A 130, B 132, and C 134 may be stored, for example, in separate databases for each test bench.

Test integration tool 140 may combine test results from multiple benches and design checkpoint times to produce and store integrated results 150. In an aspect, test integration tool 140 may first combine results across design checkpoint times, and then may combine results across benches to produce integrated results 150. Test integration tool 140 may include a time-merge tool 142 for merging test results from individual test benches across design checkpoint times to produce time-merged results for each test bench. Integration across time may combine test results from the most recent checkpoint with select test results from prior checkpoints, where test results from prior checkpoints are excluded for subcomponents of the design that existed in prior checkpoint but no long exist in the most recent checkpoint of the design. Test integration tool 140 may also include a bench-merge tool for merging the time-merged result across benches to produce the integrated results 150.

Test tool efficiency may be affected by the order for combining test results. By combining test results across time prior to combining across benches, test integration tool 140 may require less time and computing resources, for example due to the large amount to test data that test benches may generate and collect. An HDL code coverage tool for a system on a chip may track every line of HDL code for the product, and the HDL code for a product such as a system-on-a-chip might include tens of millions of lines of HDL code. Hence, the bench results 130-134 might include large amounts of data tracking every line of code added, deleted or changed in product design 110. Test integration tool 140 may require less time and fewer computing resources by integrating similar test results from individual benches across time prior to integrating across test benches.

Product design 110 may evolve over time. A snapshot of the evolving design may be fixed at certain checkpoint times and referred to herein as design checkpoints, and this may facilitate execution of test benches sequentially on the same fixed version of an evolving design.

Execution of the test benches may be performed in rounds, with each round operating on a design checkpoint snapshot. In some design processes, more than one series of testing rounds overlap, for example with a first daily round of tests occurring with daily checkpoints, and a second weekly round of different tests occurring with weekly checkpoint. In this example, test benches executed on the daily checkpoints might include light-weight tests requiring fewer test resources or that can be completed quickly (e.g. overnight), while test benches executed on weekly checkpoint might include heavy-weight tests requiring more test resources or that cannot be completed in less than a day.

As depicted in the example of FIG 1, bench result for each bench and the integrated results are all stored in separate databases. In other embodiments, some or all of these separate databases depicted in FIG. 1 may be combined into fewer databases including just a single test result database.

Product design 110 may be subdivided into separate design units, such as design units X, Y, and Z depicted in FIG. 1. Design unit subcomponents of product design 110 may be large, such as a whole processor core, or very small, such as a single line of HDL code or a single flip-flop circuit. In an aspect, product design may be a hierarchical structure of design units, where, as depicted in FIG. 1, low-level design units X.1 and X.2 may be included as part of high-level design unit X. Test benches 120-124 may then be configured to execute tests on different (potentially overlapping) subsets of the design units that make up product design 110. In the example of FIG. 1: test bench A 120 includes a configuration 121 to perform tests on design units X and Y; test bench B 122 includes a configuration 123 to perform tests on design units Y and Z; and test bench C 124 includes a configuration 125 to perform tests on design units X.1 and X.2.

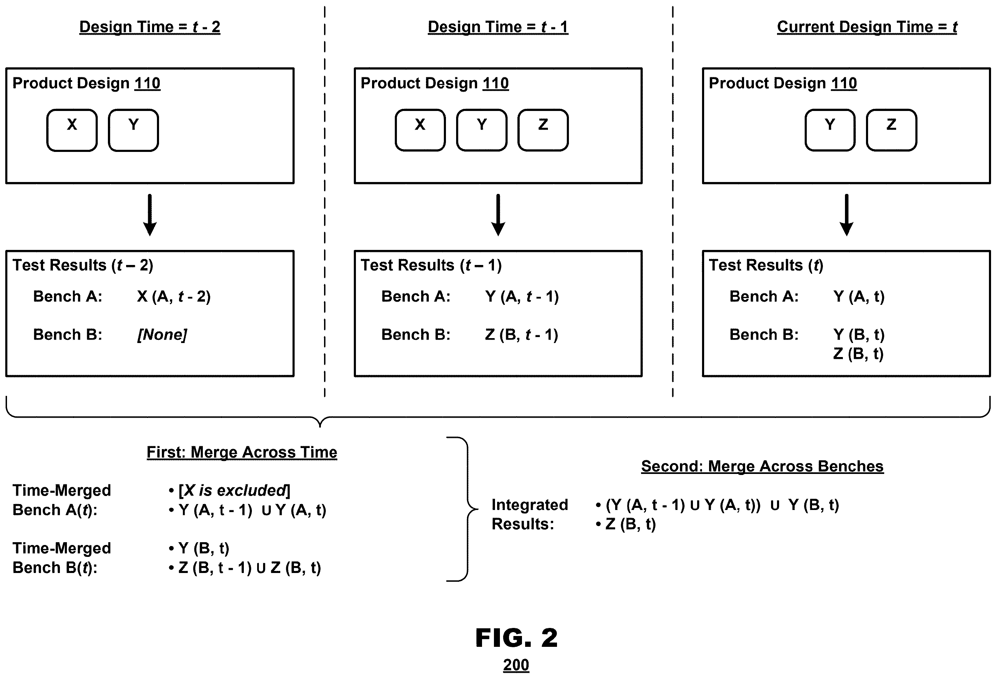

FIG. 2 depicts an example merging process 200 for example test results of product design 110 (from FIG. 1). Note that FIG. 2 depicts a simplified version of product design 110 for explanatory purposes. More specifically, the lower-level hierarchy of unit design X (including unit designs X.1 and X.2) and the corresponding tests in test bench C are not included in FIG. 2. Unit designs X.1 and X.2 may not be added to design 110 until after the design checkpoint times described in FIG. 1, and tests for unit designs X.1 and X.2 specified in configuration 125 for test bench C may not be executed until after X.1 and X.2 are added to product design 110.

FIG. 2 depicts product design 110 at three different design checkpoint times including the most recent current design time = $t$, and two prior design checkpoint times including $t-1$ and $t-2$. At the earliest design checkpoint time in the upper left of FIG. 2, product design 110 includes only unit designs X and Y, while unit design Z has not yet been created. In this example, the test results from design time $t-2$ include results for only bench A on unit design X (noted herein as X(A, $t-2$)). The configuration for bench A, as depicted in FIG. 1, includes both X and Y unit designs. However, in this example, test results for Y do not exist for checkpoint time $t-2$, perhaps because the tests for Y were not complete, or perhaps due to insufficient test resources during the $t-2$ timeframe, or many other possible reasons. Configuration 123 for bench B includes tests for unit designs Y and Z. However, in the example of FIG. 2, no test results were stored for bench B at time $t-2$. Unit design Z does not exist yet so it cannot be tested, and perhaps again tests for unit design Y did not yet exist when tests were run for checkpoint time $t-2$. This leaves just the single test result of X(A, $t-2$) available for the whole product design at checkpoint time $t-2$.

Moving right at the top of FIG. 2 to design time 2-1, product design 110 now includes three unit designs for X, Y, and Z. Test results in this case include results from bench A for unit design Y, Y(A, $t-1$), and results from bench B for unit design Z, Z(B, $t-1$). Finally, on the right side of FIG. 2, for the most recent or current design time $t$, product design 110 now includes unit designs for Y and Z. Unit design X has been removed, perhaps because a design change removed the feature from the final product. Results available for the current deign time $t$ include bench A tests of unit design Y, Y(A, $t$) and bench B tests of unit designs for both Y and Z, Y(B, $t$) and Z(B, $t$).

FIG. 2 also merging of these available test results into integrated results for the current time $t$. First, each bench's individual results are separately merged across time (lower right of FIG. 2). Integrated results for a current time may be based on any available test results corresponding to unit designs that exist at the current time and may exclude test results for unit designs that are not included in product design 110 at the current time. Hence, time-merged test results will be based on test results for unit designs that are included in the intersection of a checkpoint of product design 110 at time $t$ with checkpoints of product design 110 at prior times. For bench A, even though configuration 121 includes both X and Y, time-merged test results at current time $t$ do not include any test results for unit design X because X is not included in the product design at current time $t$. Time-merged results for bench A does include results for unit design Y because unit design Y is included in product design 110 at time $t$. Hence, time-merged results for bench A include all test available results from bench A tests for all checkpoint times. This includes bench A results for Y unit design Y at times $t$-1 and $t$, and these selected results are combined together (indicated with the union symbol "$\cup$") according to the type of test metrics and test data collected by test bench A. Therefore, the time merged result for Bench A is

$$Y\,(A,\,t\text{ - }1)\,\cup Y\,(A,\,t).$$

Turning now to bench B with configuration 123 (FIG. 1) that includes unit designs Y and Z, since product design 110 includes both Y and Z at time $t$, the time-merged results for bench B includes results test results from bench B, and including results for both unit design Y:

$$Y\,(B,\,t)$$

and unit design Z:

$$Z\,(B,\,t\text{ - }1)\cup Z\,(B,\,t).$$

After merging across time to producing time-merged results for individual test benches, the time-merged results are further merged across the test benches to produce integrated test results for the current time $t$. In an aspect, the integrated test results may preserve separate results for the separate unit designs existing in product design 110 at time $t$. In the example of FIG. 2, the design unit X does not exist in product design 110 at time $t$, so there are no test results for X in any of the time-merged results or in the subsequent integrated results. For time $t$, the integrated results are for unit design Y are:

$$(Y\,(A,\,t\text{ - }1)\cup Y\,(A,\,t))\,\cup\,Y\,(B,\,t)$$

and the integrated results for unit design Z are:

$$Z\,(B,\,t)$$

where union symbol "$\cup$" indicates a process for combining test results appropriate for the particular test metrics and may include combining measurements of test metrics and combining any additional associated test data used in the particular test bench.

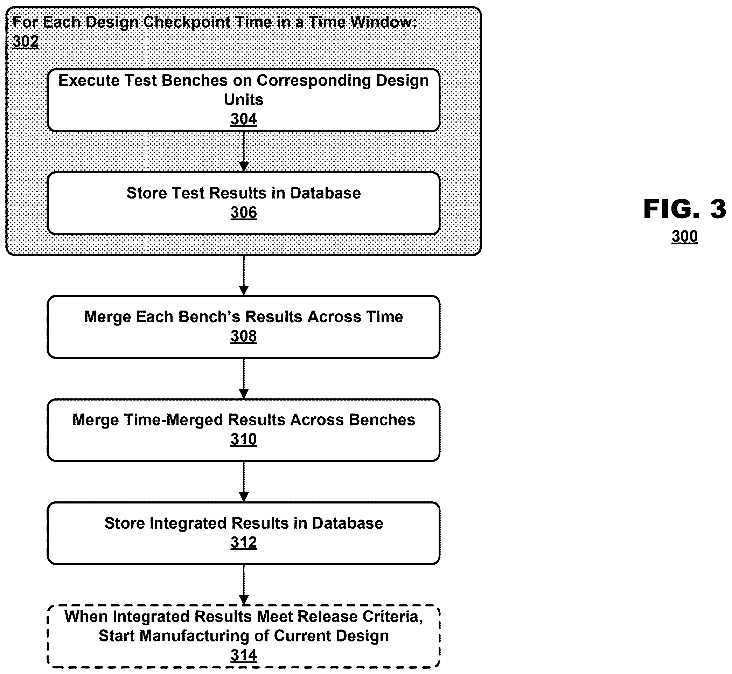

FIG. 3 depicts an example method 300 for integration of test results. Method 300 may be used in conjunction with example test system 100 of FIG. 1. Method 300 includes executing test benches on the corresponding design units in each test bench's configuration (box 304) and storing the resulting test results in a database of test results (box 306). This executing of test benches and storing of the results is repeated on each design checkpoint time within a time window (box 302). The test results are first merged across time for individual test benches (box 308), and then the resultant time-merged test results are second merged across benches (box 310) to produce integrated test result for the most recent design checkpoint time within the time window (for example, the most recent checkpoint time may be the current checkpoint time). The integrated test results may be stored in a database (box 312). Optionally, when the integrated results meet predetermined release criteria, the design from the most recent checkpoint time within the time window may be considered qualified or of sufficient quality to start a manufacturing processing (box 314).

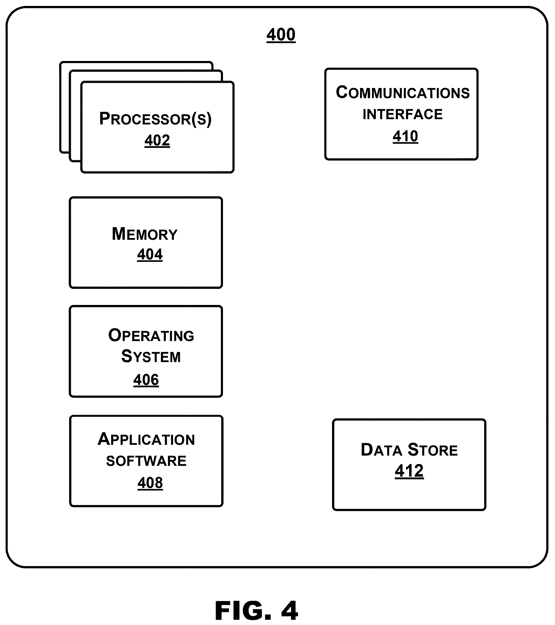

FIG. 4 depicts a block diagram of a computing-based device that may be included in an example of any of the above systems.
FIG. 4 depicts a block diagram of a computing-based device 400 that may be included in an example of any of the above systems. FIG. 4 illustrates various components of an example computing-based device 400 which are implemented as any form of a computing and/or electronic device. In some examples, computing-based device 400 is a general-purpose computer that is activated or reconfigured by a computer program stored in the computer. In other examples, computing-based device 400 is specially constructed for the intended purpose. In some examples, computing device 400 is a microprocessor used in embedded systems applications or other suitable applications. Processor(s) 402 may be employed as examples of (or an example component of) Example test system 100, test benches A 120, B 122, C 124, and test integration tool 140, and device 400 may be used to implement some or all of method 300 (FIG. 3).
Computing-based device 400 comprises one or more processors 402 which are microprocessors, controllers, or any other suitable type of processors for processing computer executable instructions to control the operation of the device. The processor(s) 402 may include at least one general-purpose processing device such as a central processing unit, microprocessor, complex instruction set computing (CISC) microprocessor, reduced instruction set computing (RISC) microprocessor, or other general-purpose processing device. In some examples, for example where a system on a chip architecture is used, the processors 402 include one or more special-purpose processing device such as a fixed function block. The special-purpose processing device may be configured to execute instructions for performing the operations and methods described herein. Platform software comprising an operating system 406 or any other suitable platform software is provided at the computing-based device to enable application software 408 to be executed on the device. Data store 412 holds system prompts, context, bot code and other data.

The computer executable instructions are provided using any computer-readable media that is accessible by computing-based device 400. Computer-readable media includes, for example, computer storage media such as memory 404 and communications media. Computer storage media, such as memory 404, includes volatile and non-volatile, removable and non-removable media implemented in any method or technology for storage of information such as computer readable instructions, data structures, program modules or the like. Computer storage media includes, but is not limited to, random access memory (RAM), read only memory (ROM), erasable programmable read only memory (EPROM), electronic erasable programmable read only memory (EEPROM), flash memory or other memory technology, compact disc read only memory (CD-ROM), digital versatile disks (DVD) or other optical storage, magnetic cassettes, magnetic tape, magnetic disk storage or other magnetic storage devices, or any other non-transmission medium that is used to store information for access by a computing device.

In contrast, communication media embody computer readable instructions, data structures, program modules, or the like in a modulated data signal, such as a carrier wave, or other transport mechanism. As defined herein, computer storage media does not include communication media. Therefore, a computer storage medium should not be interpreted to be a propagating signal per se. Although the computer storage media (memory 404) is shown within the computing-based device 400 it will be appreciated that the storage is, in some examples, distributed or located remotely and accessed via a network or other communication link (e.g., using communication interface 410). The computing-based device is able to communicate with other bots and communications network nodes via communications interface 410.

The disclosure presented herein also encompasses the subject matter set forth in the following clauses:

Example Clause 1: A method for qualifying a product design (110) of a hardware device, the product design including a plurality of unit designs, each unit design corresponding to one or more functional units in the hardware device, where the plurality of unit designs vary over a plurality of design checkpoint times including a current checkpoint time, the method comprising:

producing test results for the unit designs by partially executing a plurality of test benches on the product design at the plurality of design checkpoint times, each test bench specifying a bench subset of the plurality of the unit designs, wherein at least one of the unit designs of at least one of the bench subsets is not executed for at least one design checkpoint time;

storing, in a test database, the test results for the plurality of test benches at the plurality of design checkpoint times;

merging test results for each of the plurality of test benches across design checkpoint times to produce time-merged results for each test bench, including, for a first test bench of the plurality of test benches, merging the test results for the first test bench at the plurality of design checkpoint times to produce time-merged test results for the first test bench at the current checkpoint time;

merging the time-merged test results across the plurality of test benches to produce integrated test results (150) of the product design at the current checkpoint time, the integrated test results including an overall evaluation of the product design for the current checkpoint time; and

storing, in the test database, the integrated test results for the current checkpoint time.

Clause 2. The method of clause 1, wherein each of the test benches is associated with one or more test metrics, test results include measurements of the test metrics, and merging across time and the merging across benches includes combining a plurality of measurements of the same test metrics.

Clause 3. The method of clauses 1-2, wherein each of the test benches is associated with the same predetermined plurality of test metrics, test results include measurements of the predetermined plurality of test metrics, and the integrated test results include combined measurements for each of the predetermined plurality of test metrics across all the unit designs specified by all the test benches executed at all the design checkpoint times.

Clause 4. The method of clauses 1-3, wherein the merging for each of the plurality of test benches across design checkpoint times includes, for the first test bench:

determining a list of current unit designs for the first test bench by identifying which unit designs are included in the product design at the current checkpoint time;

producing the time-merged test results for the first test bench by combining the test results for the first test bench from the current checkpoint time with the test results for the current unit designs that were also included at prior design checkpoint times and excluding test results for unit designs from prior design checkpoint times that were not included in the list of current unit designs.

Clause 5. The method of clauses 1-4, wherein the unit designs of the product design are structured in a hierarchy such that at least one design unit of the plurality of unit designs includes at least one other design unit of the plurality of unit designs, and the merging of test results across time and across benches is based on the hierarchy.

Clause 6. The method of clauses 1-5, wherein the plurality of design checkpoint times is a sliding time window including the current checkpoint time and predetermined number of most recent design checkpoint times before the current checkpoint time, and the integrated test results do not include test results from design checkpoint times prior to a beginning of the sliding time window.

Clause 7. The method of clauses 1-6, wherein the unit designs included in the product design change between design checkpoint times.

Clause 8. The method of clauses 1-7, further comprising:

when the integrated test results for the current checkpoint time meet a predetermined release criteria, manufacturing the hardware device according the product design for the current checkpoint time.

Clause 9. A test system for qualifying a product design of a hardware device, the product design including a plurality of unit designs, each unit design corresponding to one or more functional units in the hardware device, where the plurality of unit designs vary over a plurality of design checkpoint times including a current checkpoint time, the test system comprising:

>     a test database;
>     a plurality of test benches, each configured to execute one or more tests on a bench subset of the plurality of the unit designs on the product design at the plurality of design checkpoint times, and
>     store results from the test in the test database; and
>     a test integration tool configured to
>     merge test results for each of the plurality of test benches across design checkpoint times to produce time-merged results for each test bench, including, for a first test bench of the plurality of test benches, merging the test results for the first test bench at the plurality of design checkpoint times to produce time-merged test results for the first test bench at the current checkpoint time, merge the time-merged test results across the plurality of test benches to produce integrated test results of the product design at the current checkpoint time, the integrated test results including an overall evaluation of the product design for the current checkpoint time, and
>     store, in the test database, the integrated test results for the current checkpoint time.

Clause 10. The system of clause 9, wherein each of the test benches is associated with one or more test metrics, test results include measurements of the test metrics, and merging across time and the merging across benches includes combining a plurality of measurements of the same test metrics.

Clause 11. The system of clauses 9-10, wherein each of the test benches is associated with the same predetermined plurality of test metrics, test results include measurements of the predetermined plurality of test metrics, and the integrated test results include combined measurements for each of the predetermined plurality of test metrics across all the unit designs specified by all the test benches executed at all the design checkpoint times.

Clause 12. The system of clauses 9-11, wherein the merging for each of the plurality of test benches across design checkpoint times includes, for the first test bench:

>     determining a list of current unit designs for the first test bench by identifying which unit designs are included in the product design at the current checkpoint time;
>     producing the time-merged test results for the first test bench by combining the test results for the first test bench from the current checkpoint time with the test results for the current unit designs that were also included at prior design checkpoint times and excluding test results for unit designs from prior design checkpoint times that were not included in the list of current unit designs.

Clause 13. The system of clauses 9-12, wherein the unit designs of the product design are structured in a hierarchy such that at least one design unit of the plurality of unit designs includes at least one other design unit of the plurality of unit designs, and the merging of test results across time and across benches is based on the hierarchy.

Clause 14. The system of clauses 9-13, wherein the plurality of design checkpoint times is a sliding time window including the current checkpoint time and predetermined number of most recent design checkpoint times before the current checkpoint time, and the integrated test results do not include test results from design checkpoint times prior to a beginning of the sliding time window.

Clause 15. The system of clauses 9-14, wherein the unit designs included in the product design change between design checkpoint times.

Clause 16. A non-transitory computer-readable storage medium storing instructions for qualifying a product design of a hardware device, the product design including a plurality of unit designs, each unit design corresponding to one or more functional units in the hardware device, where the plurality of unit designs vary over a plurality of design checkpoint times including a current checkpoint time, the instructions, when executed on one or more processors, cause the one or more processor to:

produce test results for the unit designs by partially executing a plurality of test benches on the product design at the plurality of design checkpoint times, each test bench specifying a bench subset of the plurality of the unit designs, wherein at least one of the unit designs of at least one of the bench subsets is not executed for at least one design checkpoint time;
store, in a test database, the test results for the plurality of test benches at the plurality of design checkpoint times;
merge test results for each of the plurality of test benches across design checkpoint times to produce time-merged results for each test bench, including, for a first test bench of the plurality of test benches, merging the test results for the first test bench at the plurality of design checkpoint times to produce time-merged test results for the first test bench at the current checkpoint time;
merge the time-merged test results across the plurality of test benches to produce integrated test results of the product design at the current checkpoint time, the integrated test results including an overall evaluation of the product design for the current checkpoint time; and
store, in the test database, the integrated test results for the current checkpoint time.

Clause 17. The non-transitory computer-readable storage medium of clause 16, wherein each of the test benches is associated with one or more test metrics, test results include measurements of the test metrics, and merging across time and the merging across benches includes combining a plurality of measurements of the same test metrics.

Clause 18. The non-transitory computer-readable storage medium of clauses 16-17, wherein each of the test benches is associated with the same predetermined plurality of test metrics, test results include measurements of the predetermined plurality of test metrics, and the integrated test results include combined measurements for each of the predetermined plurality of test metrics across all the unit designs specified by all the test benches executed at all the design checkpoint times.

Clause 19. The non-transitory computer-readable storage medium of clauses 16-18, wherein the merging for each of the plurality of test benches across design checkpoint times includes, for the first test bench:

determining a list of current unit designs for the first test bench by identifying which unit designs are included in the product design at the current checkpoint time;
producing the time-merged test results for the first test bench by combining the test results for the first test bench from the current checkpoint time with the test results for the current unit designs that were also included at prior design checkpoint times and excluding test results for unit designs from prior design checkpoint times that were not included in the list of current unit designs.

Clause 20. The non-transitory computer-readable storage medium of clauses 16-19, wherein the unit designs of the product design are structured in a hierarchy such that at least one design unit of the plurality of unit designs includes at least one other design unit of the plurality of unit designs, and the merging of test results across time and across benches is based on the hierarchy.

The application relates to improved hardware design testing techniques qualify a current design by integrating select tests completed on prior design iterations. A product design may be divided into design unit subcomponents, and multiple test benches may individually be configured to test different groups of subcomponents. The test benches may be run on a series of iterations of an evolving product design. Qualification of a most recent current iteration of the product design can be simplified by incorporating some test results from tests performed on prior iteration checkpoints of the design into the qualification of the current design by first combining test results across time for each test bench, and then combining test results across the set of test benches.

In the above detailed description, reference is made to the accompanied drawings, which form a part hereof, and which is shown by way of illustration, specific example configurations of which the concepts can be practiced. These configurations are described in sufficient detail to enable those skilled in the art to practice the techniques disclosed herein, and it is to be understood that other configurations can be utilized, and other changes may be made, without departing from the scope of the presented concepts. The above detailed description is, therefore, not to be taken in a limiting sense, and the scope of the presented concepts is defined only by the appended claims.

The above description provides specific details for a thorough understanding of, and enabling description for, various examples of the technology. One skilled in the art will understand that the technology may be practiced without many of these details. In some instances, well-known structures and functions have not been shown or described in detail to avoid unnecessarily obscuring the description of examples of the technology. It is intended that the terminology used in this disclosure be interpreted in its broadest reasonable manner, even though it is being used in conjunction with a detailed description of certain examples of the technology. Although certain terms may be emphasized below, any terminology intended to be interpreted in any restricted manner will be overtly and specifically defined as such in this Detailed Description section. Throughout the specification and claims, the following terms take at least the meanings explicitly associated herein, unless the context dictates otherwise. The meanings identified below do not necessarily limit the terms, but merely provide illustrative examples for the terms. For example, each of the terms "based on" and "based upon" is not exclusive, and is equivalent to the term "based, at least in part, on," and includes the option of being based on additional factors, some of which may not be described herein. As another example, the term "via" is not exclusive, and is equivalent to the term "via, at least in part," and includes the option of being via additional factors, some of which may not be described herein. The phrase "in one example," as used herein does not necessarily refer to the same embodiment or example, although it may. Use of particular textual numeric designators does not imply the existence of lesser-valued numerical designators. References in the singular are made merely for clarity of reading and include plural references unless plural references are specifically excluded. The term "or" is an inclusive "or" operator unless specifically indicated otherwise. For example, the phrase "A or B" means "A, B, or A and B." As used herein, the terms "component" and "system" are intended to encompass hardware, software, or various combinations of hardware and software. Thus, for example, a system or component may be a process, a process executing on a computing device, the computing device, or a portion thereof. The meaning of "a," "an," and "the" includes plural reference, and the meaning of "in" includes "in" and "on." The term "connected" means a direct electrical connection between the items connected, without any intermediate devices. The term "coupled" means a direct electrical connection between the items connected, or an indirect connection through one or more passive or active intermediary devices and/or components. The term "signal" means at least a power, current, voltage, data, electric wave, magnetic wave, electromagnetic wave, or optical signal. Based upon context, the term "coupled" may refer to a wave or field coupling effect, which may relate to a corresponding optical field, magnetic field, electrical field, or a combined electromagnetic field.

It will be understood that the configurations and/or approaches described herein are examples, and that these specific embodiments or examples are not to be considered in a limiting sense, because numerous variations are possible. As such, various systems, circuits, and/or devices may be broken into additional functions or circuits, and/or combined with other functions or circuits as may be desirable in a specific implementation. Similarly, the specific routines, procedures or methods described herein may represent one or more of any number of processing strategies. As such, various acts illustrated and/or described may be performed in the sequence illustrated and/or described, in other sequences, in parallel, or omitted. Likewise, the order of the above-described processes or methods may be changed. The subject matter thus includes all novel and non-obvious combinations and sub-combinations of the methods, processes, circuits, devices, systems and configurations, and other features, functions and/or properties disclosed herein, as well as any and all equivalents thereof.

In closing, although the various configurations have been described in language specific to structural features and/or methodological acts, it is to be understood that the subject matter defined in the appended representations is not necessarily limited to the specific features or acts described. Rather, the specific features and acts are disclosed as example forms of implementing the claimed subject matter.

## Claims

1. A method for qualifying a product design (110) of a hardware device, the product design including a plurality of unit designs, each unit design corresponding to one or more functional units in the hardware device, where the plurality of unit designs vary over a plurality of design checkpoint times including a current checkpoint time, the method comprising:

   producing test results (130, 132, 134) for the unit designs by partially executing a plurality of test benches (120, 122, 124) on the product design at the plurality of design checkpoint times, each test bench specifying a bench subset (121, 123, 125) of the plurality of the unit designs, wherein at least one of the unit designs of at least one of the bench subsets is not executed for at least one design checkpoint time;
   storing, in a test database, the test results for the plurality of test benches at the plurality of design checkpoint times;
   merging test results for each of the plurality of test benches across design checkpoint times to produce time-merged results for each test bench, including, for a first test bench of the plurality of test benches, merging the test results for the first test bench at the plurality of design checkpoint times to produce time-merged test results for the first test bench at the current checkpoint time;
   merging the time-merged test results across the plurality of test benches to produce integrated test results (150) of the product design at the current checkpoint time, the integrated test results including an overall evaluation of the product design for the current checkpoint time; and
   storing, in the test database, the integrated test results for the current checkpoint time.

2. The method of claim 1, wherein each of the test benches is associated with one or more test metrics, test results include measurements of the test metrics, and merging across time and the merging across benches includes combining a plurality of measurements of the same test metrics.

3. The method of claim 1 or claim 2, wherein each of the test benches is associated with the same predetermined plurality of test metrics, test results include measurements of the predetermined plurality of test metrics, and the integrated test results include combined measurements for each of the predetermined plurality of test metrics across all the unit designs specified by all the test benches executed at all the design checkpoint times.

4. The method of any previous claim, wherein the merging for each of the plurality of test benches across design checkpoint times includes, for the first test bench:

   determining a list of current unit designs for the first test bench by identifying which unit designs are included in the product design at the current checkpoint time;
   producing the time-merged test results for the first test bench by combining the test results for the first test bench from the current checkpoint time with the test results for the current unit designs that were also included at prior design checkpoint times and excluding test results for unit designs from prior design checkpoint times that were not included in the list of current unit designs.

5. The method of any previous claim, wherein the unit designs of the product design are structured in a hierarchy such that at least one design unit of the plurality of unit designs includes at least one other design unit of the plurality of unit designs, and the merging of test results across time and across benches is based on the hierarchy.

6. The method of any previous claim, wherein the plurality of design checkpoint times is a sliding time window including the current checkpoint time and predetermined number of most recent design checkpoint times before the current checkpoint time, and the integrated test results do not include test results from design checkpoint times prior to a beginning of the sliding time window.

7. The method of any previous claim, wherein the unit designs included in the product design change between design checkpoint times.

8. The method of any previous claim, further comprising:
   when the integrated test results for the current checkpoint time meet a predetermined release criteria, manufacturing the hardware device according the product design for the current checkpoint time.

9. A test system for qualifying a product design (110) of a hardware device, the product design including a plurality of unit designs, each unit design corresponding to one or more functional units in the hardware device, where the plurality of unit designs vary over a plurality of design checkpoint times including a current checkpoint time, the test system comprising:

   a test database;
   a plurality of test benches (120, 122, 124), each configured to

      execute one or more tests on a bench subset (121, 123, 125) of the plurality of the unit designs on the product design at the plurality of design checkpoint times, and
      store results from the test in the test database; and

   a test integration tool configured to

      merge test results for each of the plurality of test benches across design checkpoint times to produce time-merged results for each test bench, including, for a first test bench of the plurality of test benches, merging the test results for the first test bench at the plurality of design checkpoint times to produce time-merged test results for the first test bench at the current checkpoint time,
      merge the time-merged test results across the plurality of test benches to produce integrated test results (150) of the product design at the current checkpoint time, the integrated test results including an overall evaluation of the product design for the current checkpoint time, and
      store, in the test database, the integrated test results for the current checkpoint time.

10. The test system of claim 9, wherein each of the test benches is associated with one or more test metrics, test results include measurements of the test metrics, and merging across time and the merging across benches includes combining a plurality of measurements of the same test metrics.

11. The test system of claim 9 or claim 10, wherein each of the test benches is associated with the same predetermined plurality of test metrics, test results include measurements of the predetermined plurality of test metrics, and the integrated test results include combined measurements for each of the predetermined plurality of test metrics across all the unit designs specified by all the test benches executed at all the design checkpoint times.

12. The test system of any of claims 9 to 11, wherein the merging for each of the plurality of test benches across design checkpoint times includes, for the first test bench:

determining a list of current unit designs for the first test bench by identifying which unit designs are included in the product design at the current checkpoint time;
producing the time-merged test results for the first test bench by combining the test results for the first test bench from the current checkpoint time with the test results for the current unit designs that were also included at prior design checkpoint times and excluding test results for unit designs from prior design checkpoint times that were not included in the list of current unit designs.

13. The test system of any of claims 9 to 12, wherein the unit designs of the product design are structured in a hierarchy such that at least one design unit of the plurality of unit designs includes at least one other design unit of the plurality of unit designs, and the merging of test results across time and across benches is based on the hierarchy.

14. The test system of any of claims 9 to 13, wherein the plurality of design checkpoint times is a sliding time window including the current checkpoint time and predetermined number of most recent design checkpoint times before the current checkpoint time, and the integrated test results do not include test results from design checkpoint times prior to a beginning of the sliding time window.

15. A non-transitory computer-readable storage medium storing instructions for qualifying a product design (110) of a hardware device, the product design including a plurality of unit designs, each unit design corresponding to one or more functional units in the hardware device, where the plurality of unit designs vary over a plurality of design checkpoint times including a current checkpoint time, the instructions, when executed on one or more processors, cause the one or more processor to:

produce test results (130, 132, 134) for the unit designs by partially executing a plurality of test benches (120, 122, 124) on the product design at the plurality of design checkpoint times, each test bench specifying a bench subset (121, 123, 125) of the plurality of the unit designs, wherein at least one of the unit designs of at least one of the bench subsets is not executed for at least one design checkpoint time;
store, in a test database, the test results for the plurality of test benches at the plurality of design checkpoint times;
merge test results for each of the plurality of test benches across design checkpoint times to produce time-merged results for each test bench, including, for a first test bench of the plurality of test benches, merging the test results for the first test bench at the plurality of design checkpoint times to produce time-merged test results for the first test bench at the current checkpoint time;
merge the time-merged test results across the plurality of test benches to produce integrated test results (150) of the product design at the current checkpoint time, the integrated test results including an overall evaluation of the product design for the current checkpoint time; and
store, in the test database, the integrated test results for the current checkpoint time.

**FIG. 1**

100

**Design Time = _t_ - 2**

Product Design 110

X    Y

↓

Test Results (_t_ – 2)

Bench A:    X (A, _t_ - 2)

Bench B:    *[None]*

**Design Time = _t_ - 1**

Product Design 110

X    Y    Z

↓

Test Results (_t_ – 1)

Bench A:    Y (A, _t_ - 1)

Bench B:    Z (B, _t_ - 1)

**Current Design Time = _t_**

Product Design 110

Y    Z

↓

Test Results (_t_)

Bench A:    Y (A, t)

Bench B:    Y (B, t)
            Z (B, t)

**First: Merge Across Time**

Time-Merged Bench A(_t_):
- *[X is excluded]*
- Y (A, t - 1) ∪ Y (A, t)

Time-Merged Bench B(_t_):
- Y (B, t)
- Z (B, t - 1) ∪ Z (B, t)

**Second: Merge Across Benches**

Integrated Results:
- (Y (A, t - 1) ∪ Y (A, t)) ∪ Y (B, t)
- Z (B, t)

**FIG. 2**

200

EP 4 769 201 A1

**For Each Design Checkpoint Time in a Time Window:**
**302**

> **Execute Test Benches on Corresponding Design Units**
> **304**

> **Store Test Results in Database**
> **306**

**Merge Each Bench's Results Across Time**
**308**

**Merge Time-Merged Results Across Benches**
**310**

**Store Integrated Results in Database**
**312**

**When Integrated Results Meet Release Criteria, Start Manufacturing of Current Design**
**314**

**FIG. 3**
**300**

**400**

PROCESSOR(S)
**402**

COMMUNICATIONS
INTERFACE
**410**

MEMORY
**404**

OPERATING
SYSTEM
**406**

APPLICATION
SOFTWARE
**408**

DATA STORE
**412**

**FIG. 4**

# EUROPEAN SEARCH REPORT

**Application Number**

EP 25 22 6604

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 8 560 985 B1 (SAHU BIJAYA [IN] ET AL) 15 October 2013 (2013-10-15) | 1-5, 7-13,15 | INV. G06F30/33 |
| Y | * the whole document * <br> * column 1, line 66 - column 2, line 2 * <br> * column 4, line 28 - line 43 * <br> * column 5, line 16 - line 18 * <br> * column 5, line 35 - line 37 * <br> * column 6, line 44 - line 54 * <br> * column 8, line 17 - line 23 * <br> * column 8, line 52 - line 63 * <br> * column 8, line 34 - line 37 * <br> * column 8, line 21 - line 23 * <br> * column 8, line 26 - line 29 * <br> * column 9, line 31 - line 52 * <br> * column 8, line 64 - column 9, line 2 * <br> * column 9, line 53 - line 59 * <br> * column 10, line 9 - line 11 * <br> * column 10, line 43 - line 53 * <br> * column 17, line 56 - line 64 * <br> * column 18, line 5 - line 8 * <br> ----- | 6,14 | |
| Y | US 2013/007528 A1 (ZIV AVI [IL] ET AL) 3 January 2013 (2013-01-03) | 6,14 | **TECHNICAL FIELDS SEARCHED (IPC)** <br><br> G06F |
| A | * the whole document * <br> * paragraph [0004] * <br> * paragraph [0029] * <br> * paragraph [0005] * <br> * claim 8 * <br> ----- | 1-5, 7-13,15 | |

The present search report has been drawn up for all claims

| Place of search | Date of completion of the search | Examiner |
|---|---|---|
| Munich | 12 May 2026 | Rungger, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 22 6604

This annex lists the patent family members relating to the patent documents cited in  the above-mentioned European search report.
The members are as contained in the European Patent Office EDP file on
The European Patent Office is in no way liable for these particulars which are merely given for the purpose of information.

12-05-2026

| Patent document cited in search report | | Publication date | Patent family member(s) | | Publication date |
|---|---|---|---|---|---|
| US 8560985 | B1 | 15-10-2013 | NONE | | |
| US 2013007528 | A1 | 03-01-2013 | US | 2011239193 A1 | 29-09-2011 |
| | | | US | 2013007528 A1 | 03-01-2013 |

EPO FORM P0459

For more details about this annex : see Official Journal of the European Patent Office, No. 12/82